(19) Europäisches Patentamt
European Patent Office
Office européen des brevets

(11) Publication number: 0 336 400
A2

(12) # EUROPEAN PATENT APPLICATION

(21) Application number: 89105990.9

(51) Int. Cl.4: G03F 7/26

(22) Date of filing: 05.04.89

(30) Priority: 07.04.88 JP 86177/88

(43) Date of publication of application:
11.10.89 Bulletin 89/41

(84) Designated Contracting States:
DE FR GB

(71) Applicant: FUJI PHOTO FILM CO., LTD.
No. 210, Nakanuma Minami-Ashigara-shi
Kanagawa-ken(JP)

(72) Inventor: Yoshida, Susumu
c/o Fuji Photo Film Co., Ltd. 4000, Kawashiri
Yoshida-cho Haibara-gun Shizuoka-ken(JP)
Inventor: Takahasi, Hiroshi
c/o Fuji Photo Film Co., Ltd. 4000, Kawashiri
Yoshida-cho Haibara-gun Shizuoka-ken(JP)
Inventor: Kita, Nobuyuki
c/o Fuji Photo Film Co., Ltd. 4000, Kawashiri
Yoshida-cho Haibara-gun Shizuoka-ken(JP)

(74) Representative: Patentanwälte Grünecker,
Kinkeldey, Stockmair & Partner
Maximilianstrasse 58
D-8000 München 22(DE)

(54) **Developer for dry ps plates.**

(57) A developer for developing a dry presensitized plate for use in making lithographic printing plates requiring no dampening water during printing, comprising a substrate provided thereon with, in order, a primer layer, a light-sensitive layer and a silicone rubber layer, comprises (i) at least one organic solvent capable of dissolving or swelling unexposed portions of the light-sensitive layer and whose solubility in water at ordinary temperature is not more than 20% by weight; (ii) at least one basic compound; (iii) at least one surfactant; and (iv) water. The developer makes it possible to continuously and stably process a large quantities of dry presensitized plates for use in making dry lithographic printing plates without generating sludge in the developer which possibly causes clogging of a filter of an automatic developing machine.

FIG. 1

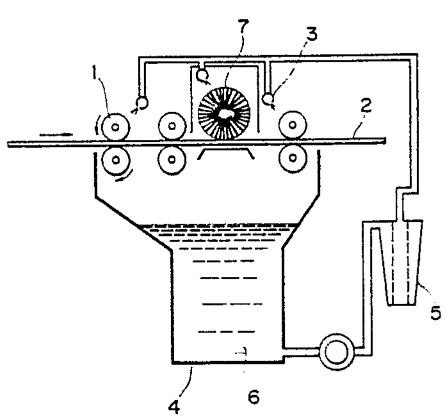


EP 0 336 400 A2

# Developer for Dry PS Plates

## BACKGROUND OF THE INVENTION

The present invention relates to a developer for a dry presensitized plate (hereunder referred to as "dry PS plate(s)") for use in making a lithographic printing plate in which a silicone rubber layer serves as ink repellent layer and which requires no dampening water during printing operation (hereunder referred to as "dry lithographic printing plate(s)").

There have been proposed a variety of dry PS plates whose silicone rubber layer serves as an ink repellent layer. Among these, the dry PS plates disclosed in Japanese Patent Publication for Opposition Purpose (hereunder referred to as "J.P. KOKOKU") Nos. 54-26923; 55-22781 and 56-23150 comprise a substrate provided thereon with in order a photohardenable light-sensitive layer and a silicone rubber layer and several tens of thousands of printed matters can be obtained using a dry lithographic printing plate prepared from such a dry PS plate without using any dampening water.

The aforementioned dry PS plate is in general subjected to a plate making process comprising the following exposure, developing processes to obtain a dry lithographic printing plate.

First of all, a dry PS plate is exposed to actinic rays through an original film which closely comes into contact with the dry PS plate. The exposed dry PS plate is immersed in a developer consisting of or mainly composed of a paraffinic hydrocarbon. As a result, the silicone rubber layer on unexposed portions gets swallen severely with the developer and is removed with or without accompanying dissolution out of the light-sensitive layer on the unexposed portions. The portion from which the silicone rubber layer is removed serves as an image area. On the contrary, although the silicone rubber layer on exposed portions slightly gets swallen with the developer, it is strongly adhered to the photohardened light-sensitive layer and remains on the surface of the plate without causing any damages even if it is strongly rubbed with a developing pad or the like. This portion serves as an ink repellent non-image area. A dry lithographic printing plate can be produced according to the aforementioned manner.

By the way, conventional developers for dry PS plates whose upper layer is silicone rubber layer, comprise a paraffinic hydrocarbon which is a swelling agent for silicone rubbers as a principal component and a developing agent. For this reason, a silicone rubber layer severely gets swallen with such a developer. This results in easy formation of scratch in the silicone rubber layer during development. Moreover, such a developer contains a great amount of combustible solvents and, therefore, there is a risk of causing a fire or explosion. In particular, when carrying out automatic developing, it is necessary to use an automatic developing machine which is designed to completely prevent a fire or explosion. Such a developing machine is quite expensive compared with automatic developing machines for processing a presensitized plate (a conventional PS plate) which can be processed with an ordinary developer mainly composed of water and thus the use thereof is less econmical.

One method for solving the foregoing problem is disclosed in Japanese Patent Application Serial (hereunder referred to as "J. P.A." No. 62-317843), the method comprising processing a dry PS plate in which a photopolymerizable light-sensitive layer is used with a developer mainly comprised of water. More specifically, the foregoing problem can be solved by using a developer in which a water-insoluble or hardly water-soluble organic solvent capable of dissolving or swelling unexposed portion of the photopolymerizable light-sensitive layer is solubilized with a surfactant. In addition, this developer has good developing properties and thus it has been possible to design a relatively inexpensive automatic developing machine if such a developer is employed.

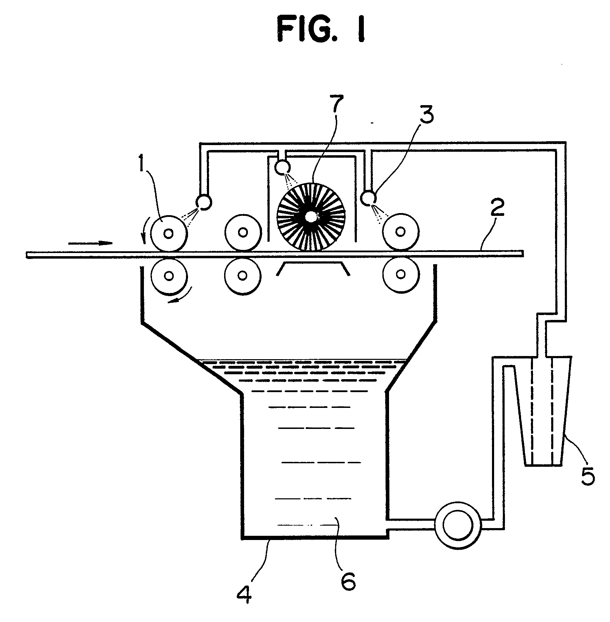

In a usual automatic developing machine for a dry PS plate 2 as shown in Fig. 1, a developer 6 is sprayed on the surface of the plate 6 to immerse it with the developer 6 and only the silicone rubber layer on unexposed light-sensitive layer is rubbed with a brush roller 7 to remove the same or the unexposed light-sensitive layer is dissolved out to simultaneously remove the silicone rubber layer thereon. In this processing apparatus, the dry PS plate 2 is conveyed towards the direction indicated by an arrow by means of a conveying means such as feed rollers 1, during which the developer 6 contained in a tank 4 is supplied to the surface of the silicone rubber layer of the PS plate 2 from nozzles 3 disposed above the conveying path through a filter 5. After supplying the developer, the surface of the silicone rubber layer is rubbed with the brush roller 7 to remove only the silicone rubber layer to form images or to remove the light-sensitive layer and the silicone rubber layer thereon simultaneously to thus complete the development. Scum of the silicone rubber generated during the development processing is removed by the filter 5.

However, when dry PS plates having a photopolymerizable light-sensitive layer are processed in large quantities (20 to 30 $m^2/\ell$) with the aforementioned developer mainly composed of water utilizing an

automatic developing machine as shown in the attached figure, a great quantities of sludge principally composed of components of the light-sensitive layer is generated in the developing solution in addition to scum of the silicone rubber layer, this leads to the clogging of the filter which is fitted for the purpose of removing the scum of the silicone rubber, in turn the circulation of the developer is inhibited and as a result, the automatic developing machine comes to a standstill.

## SUMMARY OF THE INVENTION

Accordingly, an object of the present invention is to provide a developer for automatic developing treatment, which does not generate sludge causing clogging of a filter even if a large quantities of dry PS plates are processed using an automatic developing machine and which makes it possible to stably process these plates over a long period of time, for instance, several months.

In order to overcome the foregoing disadvantages associated with conventional developers for dry PS plates, the inventors of this invention have conducted various studies to achieve the foregoing object and they have developed a developer which is prepared by incorporating basic substances into a developer mainly composed of water and which can inhibit the generation of sludge therein and prevent the clogging of a filter even if a large quantities of PS plates are processed using an automatic developing machine.

More specifically, the present invention relates to a developer for dry PS plates comprising a substrate provided thereon with in order a primer layer, a light-sensitive layer and a silicone rubber layer, the developer comprising

i) at least one organic solvent capable of dissolving or swelling unexposed portion of the light-sensitive layer and whose solubility in water at ordinary temperature is not more than 20% by weight;

ii) at least one basic compound;

iii) at least one surfactant; and

iv) water.

## BRIEF EXPLANATION OF THE DRAWING

Fig. 1 is a diagram showing an automatic developing machine for dry PS plates.

## DETAILED EXPLANATION OF THE INVENTION

In the present invention, the mechanism that the generation of sludge is prevented by adding a basic substance to a developer mainly composed of water has not yet clearly demonstrated, but it seems that the solubility of monomers, oligomers, binders in the developer is increased by the addition of basic compounds and thus they can be stably present in the developer.

The present invention will hereunder be described in more detail. First of all, the dry PS plates which may be processed with the developer of this invention will hereunder be explained in more detail.

### (Substrate)

As substrates for dry PS plates processed with the developer of this invention, dimensionally stable plate-like materials are used. Such plate-like materials include those conventionally used as substrates for lithographic printing plates and can preferably be used in the invention. Examples of such substrates are paper, paper laminated with a plastic film such as polyethylene, polypropylene or polystyrene film; metal plates such as aluminum (including alloys thereof), zinc or copper plate; films of plastics such as cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate and polyvinyl acetal; and paper or plastic films which are laminated with a film of the foregoing metal or on which the foregoing metal is deposited. Particularly preferred are aluminum plates among others because of their dimensional stability and low cost. Moreover, a composite sheet which comprises a polyethylene terephthalate film bonded to an aluminum plate as disclosed in J.P. KOKOKU No. 48-18327 is also preferably used in the invention.

(Primer Layer)

Primer layers of dry PS plates processed with the developer of the present invention should fulfill the following requirements: the primer layer sufficiently adhere to the substrate and the light-sensitive layer, is stable for a long period of time and is highly resistant to solvents used in the developer.

In addition, if the primer layer on image areas is exposed after development processing, the primer layer may be stained during or after development to thus make the examination of the resulting plate easy. Therefore, it is preferable to use a substance which can easily be stained, as a material for such a primer layer.

Examples thereof which satisfy the foregoing requirements are those obtained by hardening gelatin with a proper hardener. Moreover, there may be used those obtained by heating epoxy resins or polyurethane resins with a hardener to solidify the same, but it is preferred to use hardened gelatin (see J.P.A. Nos. 61-281194, 62-141114 and 62-331114) and casein or the like.

The coated amount of gelatin primer is preferably in the range of 0.1 to 50 $\mu$ , more preferably 0.5 to 20 $\mu$. The term "coated amount" herein means the thickness of the primer layer measured after drying.

(Light-sensitive Layer)

The light-sensitive layer of the PS plates used in the present invention may have the following composition:

(1) i) monomers which have a boiling point of not less than 100 °C, are non-volatile at room temperature and have at least one photopolymerizable ethylenically unsaturated double bond --- 1.0 to 99.9 parts by weight

ii) photopolymerization initiator --- 0.1 to 20.0 parts by weight

iii) optionally a heat polymerization inhibitor --- 0.01 to 1.0 parts by weight

iv) optionally polymers or inorganic powder as a filler for imparting retention of shape to the photopolymerizable adherent layer --- 0.01 to 95.0 parts by weight

Each component will hereunder be explained.

i) Photopolymerizable Monomer or Oligomer

Typical examples of photopolymerizable monomers and oligomers thereof include (meth)acrylates or (meth)acrylamides derived from primary alcohols or primary amines having not more than 30 carbon atoms and a boiling point of not less than 100 °C; and (meth)acrylates or (meth)acrylamides derived from polyhydric alcohols or polyfunctional amines having not more than 80 carbon atoms and a boiling point of not less than 100 °C.

Typical monomers useful in the invention will be listed below. Some of these may also be used as starting materials for oligomers useful in the invention.

i-i) (Meth)acrylates of the following alcohols:

methanol, ethanol, propanol, pentanol, cyclohexanol, octanol, undecanol, bornyl alcohol, polymethylene glycol, ethylene glycol, polyethylene glycol, propylene glycol, polypropylene glycol, glycerol, trimethylolmethane and pentaerythritol.

i-ii)

adducts of glycidyl acrylate and a hydrogen halide, amine, carboxylic acid or the like and polymers obtained by ring opening polymerization of glycidyl group, for instance, G-O-CO-$CH_2CH_2$-CO-O-G, Cl -G, GN(G)-$CH_2$-Phe-$CH_2$-$N(G)_2$, -(CH-CH($CH_2$-O-CO-C($CH_3$) = CH2)-O$)_n$ -, wherein G is -$CH_2$CH(OH)-$CH_2$-O-CO-C($CH_3$) = $CH_2$ and Phe is a p-phenylene group.

i-iii) (Meth)acrylamide derivatives listed below:

(meth)acrylamide, N-methylol (meth)acrylamide, N-methoxymethyl (meth)acrylamide, methylene bis-(meth)acrylamide, hexamethylene bis(meth)acrylamide, diacetone acrylamide and hydroxymethyl diacetone acrylamide.

As examples of the most useful monomer which may be incorporated into the photopolymerizable light-sensitive layer used in the invention, the following compounds may be listed:
ethylene glycol di(meth)acrylate, polyethylene glycol di(meth)acrylate, trimethylolethane tri(meth)acrylate, trimethylolpropane tri(meth)acrylate, pentaerythritol tetra(meth)acrylate, pentaerythritol tri(meth)acrylate, dipentaerythritol penta(meth)acrylate, dipentaerythritol hexa(meth)acrylate.

ii) Polymerization Initiators

Typical examples of polymerization initiators used in the present invention include the following compounds:

ii-i) benzophenone derivatives such as benzophenone, Michler's ketone, xanthone and anthrone;

ii-ii) benzoin derivatives such as benzoin, benzoin methyl ether and benzoin ethyl ether;

ii-iii) quinones such as p-benzoquinone, β -naphthoquinone and β -methylanthraquinone;

ii-iv) sulfur compounds such as dibenzyl disulfide and di-n-butyl disulfide;

ii-v) azo or diazo compounds such as 2-azo-bis-isobutyronitrile, 1-azo-bis-1-cyclohexane carbonitrile, p-diazobenzylethylaniline and Congo red;

ii-vi) halogen compounds such as carbon tetrabromide, silver bromide, α -chloromethylnaphthalene and trihalomethyl-s-triazine;

ii-vii) peroxides such as benzoyl peroxide;

ii-viii) uranyl salts such as uranyl nitrate.

iii) Heat Polymerization Inhibitors

As heat polymerization inhibitors there may be used hydroquinone derivatives, phenol derivatives, nitro-substituted benzene, tertiary amines and phenothiazine derivatives.

iv) Other Components

Examples of fillers and additives are fine powder of inorganic substances such as colloidal silica, calcium carbonate, magnesium carbonate and iron oxides; and resins such as polyvinyl acetate, poly(meth)-acrylate, polyethylene having a molecular weight of several thousands, polypropylene, vinyl polymers, for instance, polyvinyl chloride and polyvinylidene chloride, and unhardened resol phenol resins, urea resins, melamine resins, epoxy resins and unsaturated polyester resins.

In addition to the foregoing compounds, the light-sensitive layer may further contain dyes or pigments for the purpose of staining the layer. Moreover, it may further contain pH indicators or the like as an agent or a composition for obtaining a visible image immediately after imagewise exposure.

(2) Photocross-linkable resin composition comprising polyesters, polyacrylates, polyvinyl alcohol derivatives or epoxy resin derivatives having at least one group represented by the following formulas in its main chain or in the side chains thereof and optionally a light sensitizer:

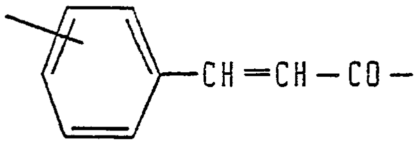

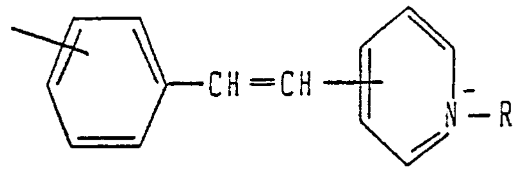

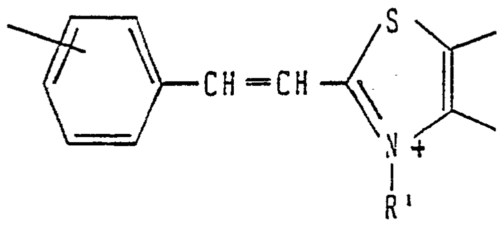

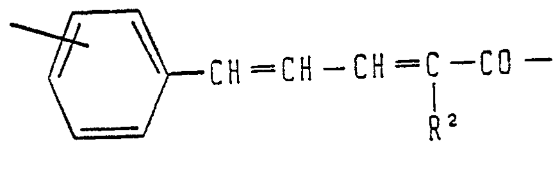

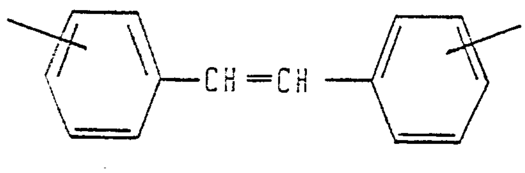

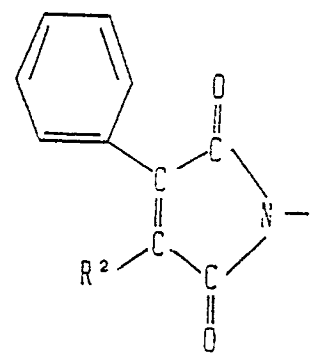

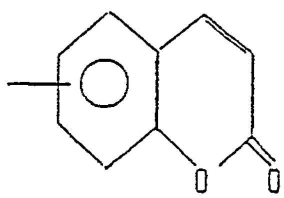

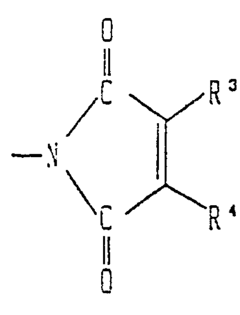

In the above formulas, R and R′ each represents an alkyl group having 1 to 10 carbon atoms and $R^2$ represents a hydrogen atom, a halogen atom, an alkyl group having 1 to 10 carbon atoms or a cyano group. $R^3$ and $R^4$ each represents an alkyl group provided that $R^3$ and $R^4$ may be bonded together to form a 5- or 6-membered ring.

The molecular weight of the foregoing polymers is not restricted to a specific one so far as they are soluble in solvents used. However, it is desirable to select such polymers having a molecular weight ranging from 1,000 to several tens of thousands. As such polymers, particularly preferred are light-sensitive polymers having light-sensitive groups in the main chain such as light-sensitive polyesters derived from p-phenylene diacrylate and a diol as disclosed in U.S. Patent Nos. 3,030,208 and 3,707,373; light-sensitive polymers such as light-sensitive polyesters derived from 2-properidene malonates such as cinnamylidene malonate and bifunctional glycols as disclosed in U.S. Patent Nos. 2,956,878 and 3,173,787; light-sensitive polymers as disclosed in U.S. Patent Nos. 2,690,966; 2,752,372 and 2,732,301 such as cinnamates of hydroxyl group-containing polymers such as polyvinyl alcohol, starch, cellulose and simulant thereof (e.g., light-sensitive polymers as disclosed in U.S. Patent Nos. 2,690,966; 2,752,372 and 2,732,301); and polymers as disclosed in Japanese Patent Un-examined Publication (hereunder referred to as "J.P.

KOKAI") Nos. 58-25302 and 59-17550.

Examples of photosensitizers which may be incorporated into the foregoing light-sensitive resin layer are those disclosed in U.S. Patent Nos. 2,610,120; 2,670,285; 2,670,286; 2,670,287; 2,670,966; 2,732,301; 2,835,656; 2,956,878; 3,023,100; 3,066,117; 3,141,770; 3,173,787; 3,357,831; 3,409,593; 3,418,295; 3,453,110; 3,475,617; 3,661,969; 3,575,929; 3,582,327; 3,647,470; 3,721,566;and 3,737,319 and specific examples of particularly preferred photosensitizers are 2-benzoylmethylene-1-methyl-β-naphthothiazoline, 5-nitroacenaphthene, β -chloroanthraquinone, 1,2-benzalanthraquinone, p,p′-tetraethyldiamin odiphenyl ketone, p,p′-dimethylaminobenzophenone and 4-nitro-2-chloroaniline. The amount of the sensitizers preferably ranges from 0. 5 to 15% by weight and particularly preferred amount thereof ranges from 2 to 8% by weight on the basis of the weight of the polymer.

(3) Preferred Light-sensitive Layer

More preferably, the light-sensitive layer of the dry PS plate used in the present invention is composed of a water-soluble light-sensitive composition which comprises:

a) copolymers which are soluble in water or get swallen with water at ordinary temperature and whose copolymerization components are at least a monomer represented by the following general formula (I):

$CH_2 = CR\text{-}CO\text{-}Z\text{-}C(R_4)(R_5)\text{-}C(R_3) = C(R_2)(R_1)$ (I)

(in the formula (I), R represents a hydrogen atom or a methyl group; $R_1$ to $R_5$ each represents a hydrogen atom, a halogen atom, a carboxyl group, a sulfo group, a nitro group, a cyano group, an amido group, an amino group, an alkyl group, an aryl group, an alkoxy group, an aryloxy group, an alkylamino group, an arylamino group, an alkylsulfonyl group or an arylsulfonyl group; and Z represents an alkylsulfonyl group or an arylsulfonyl group; and Z represents an oxygen atom, a sulfur atom or a group -NH- or -NR′- (wherein R′ is an alkyl group)) and an ethylenically unsaturated monomer having hydrophilic group(s);

b) a monomer or an oligomer having at least one photopolymerizable ethylenically unsaturated double bond; and

c) a photopolymerization initiator.

Each component of the water-soluble light-sensitive composition will hereinafter be explained.

a) Copolymers

Examples of the preferred monomers represented by the general formula (I) are allyl acrylate, $CH_2 = CH\text{-}COOCH_2CH = CH\text{-}Ph$, $CH_2 = C(CH_3)\text{-}COOCH_2\text{-}C(CH_2OCH_2CH_2) = CH\text{-}Ph$, $CH_2 = CH\text{-}COO\text{-}CH(Ph)\text{-}C(CH_3) = CH_2$, and $CH_2 = CH\text{-}COOCH_2CH = CH\text{-}Phe\text{-}OCH_3$ (wherein Ph and Phe represent a phenyl group and p-phenylene group respectively).

On the other hand, examples of ethylenically unsaturated monomers having hydrophilic group(s) include ethylenically unsaturated monomers having an alkali metal salt or an ammonium salt of a carboxyl group, a sulfonyl group, or a phosphonyl group or ethylenically unsaturated monomers such as acrylamide, vinyl pyrrolidone and vinyl alcohol.

Examples of the resultant copolymers include those obtained by neutralizing a polymer having groups carrying unsaturated double bond and carboxyl groups in the side chains with an alkali metal hydroxide or an organic amine, as disclosed in J.P. KOKAI No. 59-46643. Among these, particularly preferred is one obtained by neutralizing a copolymer of allyl methacrylate and methacrylic acid with an alkali. The acid value of the copolymer prior to the neutralization with an alkali is preferably not less then 20 to impart water-solubility thereto.

Examples of alkali substances used for neutralizing the copolymers are alkali metal hydroxides or organic amines and more specifically preferably used include sodium hydroxide, potassium hydroxide, lithium hydroxide, monoethanolamine, diethanolamine and triethanolamine.

Preferred copolymer used in the light-sensitive layer in the present invention can be prepared by copolymerizing at least a monomer represented by the formula (I) having unsaturated group(s) and an ethylenically unsaturated monomer having hydrophilic group(s), but the copolymer may comprise another monomer, as a third component, such as an alkyl (meth)acrylate, benzyl (meth)acrylate, 2-hydroxyethyl (meth)acrylate or acrylonitrile.

The amount of the structural unit represented by the formula (I) and that of the structural unit derived

from the ethylenically unsaturated monomer having hydrophilic group(s) present in the copolymers used in the present invention are, expressed in copolymerization molar ratio, 10 to 90 mole% and 5 to 60 mole%, preferably 40 to 85 mole% and 10 to 30 mole% respectively. In addition, the molecular weight of the copolymers are desirably in the range of 10,000 to 500,000, more desirably 20,000 to 200,000.

b) Photopolymerizable Monomers and Oligomers

Examples of the monomers or oligomers having at least one photopolymerizable ethylenically unsaturated double bond which is incorporated into the water-soluble light-sensitive composition used in the invention are monofunctional (meth)acrylates such as polyethylene glycol mono(meth)acrylate, polypropylene glycol mono(meth)acrylate and phenoxyethyl (meth)acrylate; those obtained by adding ethylene oxide or propylene oxide moieties to polyfunctional alcohols such as glycerin and trimethylolethane and then esterified with (meth)acrylic acids such as polyethylene glycol di(meth)acrylate, trimethylolethane tri(meth)acrylate, neopentyl glycol di(meth)acrylate, pentaerythritol tetra(meth)acrylate, pentaerythritol tetra(meth)acrylate, dipentaerythritol hexa(meth)acrylate, hexanediol di(meth)acrylate, trimethylolpropane tri(acryloyloxyethyl) ether, tri(acryloyloxyethyl) isocyanurate, calcium (meth)acrylate, barium (meth)acrylate, urethane acrylates as disclosed in J.P. KOKOKU Nos. 48-41708 and 50-6034 and J.P. KOKAI No. 51-37193; polyester acrylates as disclosed in J.P. KOKAI No. 48-64183 and J.P. KOKOKU Nos. 49-43191 and 52-30490; polyfunctional (meth)acrylate such as epoxy acrylates obtained by reacting epoxy resins and (meth)-acrylic acid; and N-methylolacrylamide derivatives as disclosed in U.S. Patent No. 4,540,649. Moreover, those which are disclosed as photohardenable monomers and oligomers in NIPPON SETCHAKU KYOKAI SHI (Bulletin of Japan Adhesives Association), Vol. 20, No. 7, pp. 300-308 may be used in the invention.

The weight ratio of these monomers or oligomers to the polymer (a) preferably ranges from 0:10 to 7:3, more preferably 1.5:8.5 to 5:5.

c) Photopolymerization Initiators

As the photopolymerization initiators used in the water-soluble light-sensitive composition in the invention, the photopolymerizable initiators listed above can be used, but in particular water-soluble photopolymerization initiators given below are useful. Specific examples thereof are 1-(4′-dodecylphenyl)-2-hydroxy-2-methylpropane, and compounds represented by the following formulas:

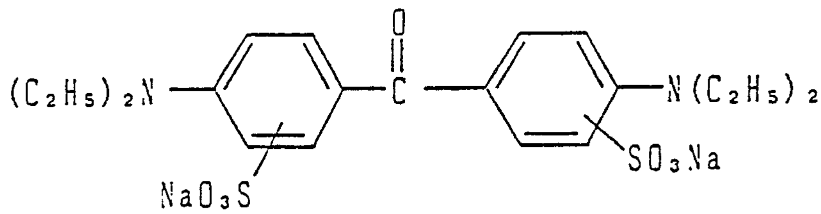

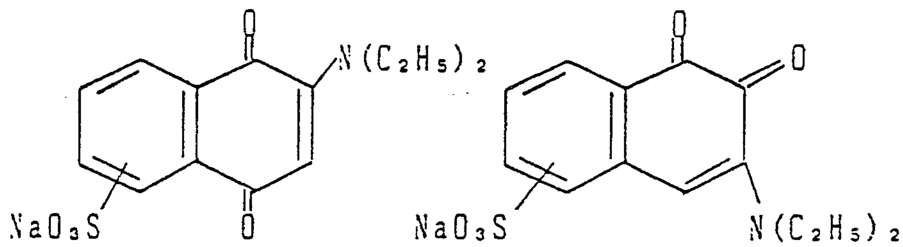

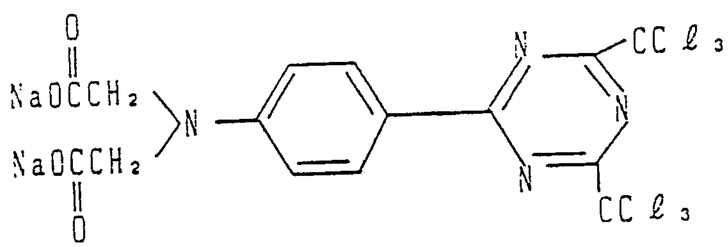

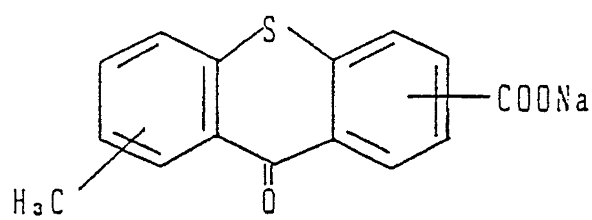

The amount of these photopolymerization initiators to be added ranges from 0.1 to 20% by weight, more preferably 1 to 10% by weight on the basis of the total weight of the light-sensitive composition.

The light-sensitive composition may preferably comprise a heat polymerization inhibitor and specific examples thereof useful include hydroquinone, p-methoxyphenol, di-t-butyl-p-cresol, pyrogallol, t-butylcatechol, benzoquinone, 4,4′-thiobis(3-methyl-6-t-butylphenol), 2,2′-methylenebis(4-methyl-6-t-butylphenol) and 2-mercaptobenzimidazole. Moreover, the light-sensitive composition may further contain dyes or pigments for the purpose of staining the light-sensitive layer and pH indicators or the like as an agent or a composition for obtaining a visible image immediately after imagewise exposure. If necessary, it may further comprise other water-soluble polymers such as polyvinyl alcohol, polyvinyl pyrrolidone, polyethylene glycol, polyvinyl alcohol partially modified with acetal, water-soluble nylon, water-soluble urethane, gum arabic, water-soluble cellulose derivatives and gelatin.

The light-sensitive layer explained above may have any thickness, but it is preferably as thin as possible since images are formed as concave portions remaining after removing the silicone rubber layer or both the silicone rubber and the light-sensitive layers. It is in general not more than 10 $\mu$ , particularly 0.1 to 5$\mu$ .

(Silicone Rubber Layer)

The silicone rubber layer used in the invention mainly comprises linear organic polysiloxane having the following repeating units and a molecular weight ranging from several thousands to several tens of thousands:

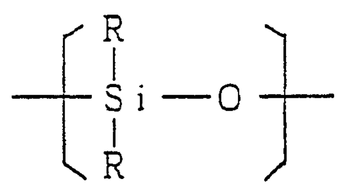

In the formula, R is an alkyl group having 1 to 10 carbon atoms or a phenyl group, but preferred are those in which not less than 60% of R is methyl group. Such a linear organic polysiloxane is in general converted to cross-linked silicone rubber by the addition of a reactive cross-linking agent, but they are roughly divided into condensation type silicone rubber compositions and addition type silicone rubber compositions depending on the kinds of the cross-linking agents used.

So-called condensation type silicone rubber composition comprises a combination of a polymeric organopolysiloxane having at least two reactive groups capable of being condensed in a molecule and a cross-linking agent used in room temperature (low temperature) hardening silicone rubber. Specific examples of such cross-linking agents are silanes such as acetoxysilane, ketoximesilane, aminoxysilane, amidosilane, alkoxysilane and hydroxysilane with or siloxanes which are condensates thereof having a low degree of polymerization and organohydrogen polysiloxane. The silicone rubber composition may further comprise reactive silane compounds having allylisocyanurate group(s), reactive silane compounds having aminoalkyl group(s) in order to enhance the adhesion between the light-sensitive layer and the silicone rubber layer to thus prevent the lowering of the adhesion between the layers over a long period of time.

The amount of the foregoing reactive cross-linking agents and/or reactive silane compounds to be incorporated into the silicone rubber layer preferably ranges from 0.05 to 10% by weight, more preferably 0.1 to 5% by weight. The adherent components may be used in combination.

Moreover, the silicone rubber layer in general contains a catalyst such as organotin compounds in a small amount in addition to the foregoing components.

On the other hand, the addition type silicone rubber composition provides a cross-linked silicone rubber due to an addition reaction of groups ≡ SiH and -CH = CH- and in general such cross-linked silicone rubber is obtained by the reaction of a polyvalent hydrogen organopolysiloxane and a polysiloxane compound having at least two -CH = CH- groups: capable of being condensed in a molecule. For instance, there is known a composition which comprises:

(1) an organopolysiloxane having at least two alkenyl groups (more desirably vinyl group) directly bonded to the silicon atom in a molecule --- 100 parts by weight

(2) an organohydrogen polysiloxane having at least two ≡ SiH groups in a molecule --- 0.1 to 1,000 parts by weight

(3) a catalyst for addition --- 0.00001 to 10 parts by weight

The alkenyl groups of the component (1) may exist at the terminus or in the middle of the molecular chain and the organopolysiloxane may have groups other than alkenyl group, such as substituted or unsubstituted alkyl groups and aryl groups. The component (1) may contain a small amount of hydroxyl groups. The component (1) not only forms a silicone rubber through the reaction with the component (2), but also serves to impart adherence to the light-sensitive layer. The hydrogen atom of the component (2) may exist at the terminus or in the middle of the molecular chain. The organic groups of the component (2) include those listed above in connection with the component (1). The organic groups of the components (1) and (2) are preferably composed of not less than 60% of methyl groups on the basis of the total number of groups to improve the ink repellent properties of the resultant plate. The molecular structure of the components (1) and (2) may be linear, cyclic or branched one. It is preferable that the molecular weight of at least one of them be greater than 1,000 in view of physical properties of the rubber and further the molecular weight of the component (1) is preferably greater than 1,000.

Examples of the component (1) include α, ω-divinylpolydimethyl siloxane and (methylvinylsiloxane) (dimethylsiloxane) copolymer whose both termini are methyl groups and examples of the component (2) are

polydimethylsiloxane having methyl groups on both termini, α, ω - dimethylpolymethyl hydrogen siloxane, (methyl hydrogen siloxane) (dimethylsiloxane) copolymer whose both termini are methyl groups and cyclic polymethyl hydrogen siloxane.

The component (3), a catalyst for addition reaction, may be selected from known ones, but particularly preferred are platinum compounds and examples thereof are metal platinum, platinum chloride, chloroplatinic acid and platinum coordinated with olefins. It is also possible to add, to the composition, a cross-linking inhibiting agent such as vinyl group-containing organopolysiloxane, for instance, tetracyclo-(methylvinyl) siloxane, alcohols having a carbon-carbon triple bond, acetone, methyl ethyl ketone, methanol, ethanol and propylene glycol monomethyl ether to control a hardening speed of a composition.

These compositions cause an addition reaction at an instance when the foregoing three components are mixed together to start hardening. The hardening speed abruptly increases as the reaction temperature rises. Therefore, for the purpose of elongating the pot life of the composition till it is converted to rubber, the composition is preferably kept at a temperature as low as possible, while for the purpose of shortening the hardening time of the rubber composition on the light-sensitive layer, the composition is preferably held at a temperature as high as possible provided that the properties of the substrate and the light-sensitive layer are not changed till the composition is completely hardened in view of obtaining a stable adhesion to the light-sensitive layer.

The silicone rubber layer in the present invention serves as an ink repellent layer. Therefore, preferred thickness thereof ranges from 0.5 to 5μ. This is because if it has a small thickness, the ink repellency is lowered and cracks are easily formed while if it has a large thickness, the developability thereof is lowered.

(Protective Layer)

A protective layer such as a plastic film may be provided onto the surface of the silicone rubber of the dry PS plate used in the invention according to need. Examples of proper plastic films are those of polyethylene, polypropylene, polyvinyl chloride, polyvinylidene chloride, polyvinyl alcohol or cellophane.

The dry PS plates explained above can effectively be processed with the developer of this invention utilizing an automatic developing machine as shown in Fig. 1 continuously and stably for a long period of time. Such a developer of the invention will now be explained in more detail below.

(Developer)

The developer of the present invention has the following composition:

i) at least one organic solvent which dissolves or swells unexposed portions of the light-sensitive layer and whose solubility in water is not more than 20% by weight at room temperature (20°C);

ii) at least one basic compound;

iii) at least one surfactant; and

iv) water.

Each component will hereunder be explained in more detail.

i) Organic Solvents

Examples of the organic solvents i) capable of dissolving or swelling unexposed areas of the light-sensitive layer and whose solubility in water at room temperature is not more than 20% by weight include diisobutyl ketone, acetophenone, isophorone, diethyl succinate, methyl benzoate, diethyl oxalate, dimethyl phthalate, isobutyl acetate, benzyl benzoate, ethylene glycol monophenyl ether, ethylene glycol dibutyl ether, ethylene glycol benzyl ether, diethylene glycol di-n-butyl ether, ethylene glycol diacetate, n-amyl alcohol and benzyl alcohol.

However, the invention is not restricted to these specific examples. Among these, particularly preferred are diethyl succinate, dimethyl phthalate, benzyl benzoate, ethylene glycol monophenyl ether, diethylene glycol di-n-butyl ether, ethylene glycol diacetate and benzyl alcohol. These organic solvents may be used alone or in combination in the developer of this invention.

The amount of these organic solvents to be incorporated into the developer composition ranges from 1 to 30% by weight, preferably 2 to 20% by weight of the total weight of the composition.

ii) Basic Compounds

The term "basic compound(s)" used in the present invention means bases commonly used in the field of chemistry and includes both inorganic and organic bases.

Examples of the organic bases include ammonia, hydrazine, hydroxylamine, and organic bases having 1 to 30 carbon atoms. Specific examples thereof are ammonia (ammonium hydroxide), amine compounds (including primary, secondary, and tertiary amines, monoamines, diamines, triamines, tetraamines, polyamines; aliphatic linear amines, aliphatic cyclic amines, aromatic amines, heterocyclic amines) such as methylamine, ethylamine, dimethylamine, diethylamine, trimethylamine, triethylamine, propylamine, butylamine, amylamine, dipropylamine, dibutylamine, diamylamine, tripropylamine, tributylamine, methyldiethylamine, ethylenediamine, trimethylenediamine, tetramethylenediamine, polyethyleneimine, benzylamine, N,N-dimethylbenzylamine, N,N-diethylbenzylamine, N,N-dipropylbenzylamine, o-, m- or p-methoxy or methyl-benzylamine, N,N-di(methyoxybenzyl)amine. $\beta$ -phenylethylamine, $\epsilon$, $\delta$ -phenylamylamine, $\gamma$ -phenylpropylamine, cyclohexylamine, aniline, monomethylaniline, dimethylaniline, toluidine, benzidine, $\alpha$ - or $\beta$ -naphthylamine, o-, m- or p-phenylenediamine, pyrrolidine, piperidine, piperazine, morpholine, urotropin, diazabicycloundecane, pyrrole, pyridine, quinoline, hydrazine, phenylhydrazine, N,N′-diphenylhydrazine, hydroxylamine, semicarbazide, tetraalkyl ammonium hydroxide, aminobenzoic acid, formamide, acetamide, N,N-dimethylformamide, N,N-dimethylacetamide, acetoanilide, monoethanolamine, diethanolamine, triethanolamine, 2-(2-aminoethyl)-ethanol, 2-amino-2-methyl-1,3-propanediol, 2-amino-1,3-propanediol and 2-amino-2-hydroxymethyl-1,3-propanediol; amine derivatives such as acid amides, or salts of amines and carboxylic acids such as salts of octanoic acid and monoethanolamine or diethanolamine.

In addition, there may also be used such alkali metal alkolates as sodium methylate, sodium ethylate, sodium propylate, potassium methylate, potassium ethylate, potassium propylate, lithium methylate and lithium ethylate and such alkali metal amides as amide, ethylamide and dipropylamide of sodium, potassium and lithium.

Examples of inorganic bases are hydroxides, carbonates, bicarbonates, phosphates, silicates and metasilicates of alkali metals and alkaline earth metals such as sodium hydroxide, potassium hydroxide, lithium hydroxide, calcium hydroxide, barium hydroxide, sodium carbonate, potassium carbonate, lithium carbonate, calcium carbonate, barium carbonate, sodium bicarbonate, potassium bicarbonate, sodium phosphate, potassium phosphate, sodium silicate, potassium silicate and sodium metasilicate.

These basic compounds may be used alone or in combination in the invention. The amount of these basic compounds to be incorporated into the developer composition vary depending on the basicity and solubility of each compound, but it is selected so that a pH value of the solution used ranges from 8.5 to 11.5, preferably 9 to 10.5.

iii) Surfactants

In the present invention, any surfactants such as anionic, non-ionic, cationic and amphoteric ones may be used, but particularly preferred are anionic and non-ionic surfactants.

Examples of the anionic surfactants are salts of aliphatic acids, salts of abietic acid, hydroxyalkane sulfonate salts, alkane sulfonate salts, dialkylsulfosuccinate salts, linear alkylbenzene sulfonate salts, branched alkylbenzene sulfonate salt, alkylnaphthalene sulfonate salts, alkyl diphenyl ether sulfonate salts, alkylphenoxy polyoxyethylenepropyl sulfonate salts, salts of polyoxyethylene alkylsulfophenyl ethers, sodium salts of N-methyl-N-oleyltaurine, disodium salts of N-alkylsulfosuccinic acid amides, salts of petroleum sulfonic acids, sulfated castor oil, sulfated tallow, sulfate ester salts of aliphatic alkyl esters, salts of alkylsulfate esters, salts of polyoxyethylene alkyl ether sulfate esters, salts of aliphatic acid monoglyceride sulfate esters, sulfate ester salts of polyoxyethylene alkylphenyl ethers, sulfate ester salts of polyoxyethylene styrylphenyl ethers, alkyl phosphate ester salts, polyoxyethylene alkyl ether phosphate ester salts, polyoxyethylene alkylphenyl ether phosphate ester salts, partially saponified copolymers of styrene-maleic anhydride and condensates of naphthalene sulfonate salt-formalin.

Particularly preferably used are alkylnaphthalene sulfonate salts, alkyl diphenyl ether sulfonate salts, linear alkylbenzene sulfonate salts, and polyoxyethylene alkylphenyl ether sulfate ester salts, among others.

Examples of the non-ionic surfactants are polyoxyethylene alkyl ethers, polyoxyethylene alkylphenyl ethers, polyoxyethylene polystyrylphenyl ethers, polyoxyethylene polyoxypropylene alkyl ethers, partial esters of glycerin and fatty acids, partial esters of sorbitan and fatty acids, partial esters of pentaerythritol and fatty acids, propylene glycol monofatty acid esters, partial esters of sucrose and fatty acids, partial

esters of polyoxyethylene sorbitan and fatty acids, partial esters of polyoxyethylene sorbitol and fatty acids, polyethylene glycol fatty acid esters, partial esters of polyglycerin and fatty acids, castor oils modified with polyoxyethylene, partial esters of polyoxyethylene glycerin and fatty acids, fatty acid diethanolamides, N,N-bis-2-hydroxyalkylamines, polyoxyethylene alkylamines, triethanolamine fatty acid esters, polyoxyethylene-polyoxypropylene block copolymers and trialkylamine oxides. Particularly preferably used are polyoxyethylene alkylphenyl ethers, and polyoxyethylene-polyoxypropylene block copolymers.

Examples of cationic surfactants are alkylamine salts, quaternary ammonium salts, polyoxyethylene alkylamine salts, and polyethylene polyamine derivatives.

These surfactants may be used alone or in combination in the invention. The content of these surfactants in the developer composition ranges from 0.01 to 30% by weight, preferably 0.1 to 20% by weight on the basis of the total weight of the composition.

The developer composition may further comprise a dye such as Crystal Violet or Astrazon Red to stain the image areas simultanously with the development.

(Method for Making Plates)

The development may be carried out by any manual development methods, for instance, by rubbing the surface of an exposed PS plate with a development pad containing a developer or by rubbing the surface thereof with a developing brush after pouring a developer on the surface of the plate. However, if a great quantities of PS plates are processed using an automatic developing machine as shown in Fig. 1, the developer of the present invention shows its effects most efficiently. The silicone rubber layer on the unexposed image areas is removed by the development to thus expose the surface of the light-sensitive layer or both the silicone rubber layer and the light-sensitive layer of the exposed image areas are simultaneously removed by development to thus expose the surface of the primer layer and the exposed portions serve as ink receiving portions. In addition, it is also possible to stain the image portion simultaneously with development by incorporating a dye such as Crystal Violet or Astrazon Red into the developer. Alternatively, the image areas may be stained using a staining solution containing Crystal Violet or Astrazon Red after the development.

If a great quantities of dry PS plates are processed with the developer of the present invention utilizing an automatic developing machine as shown in Fig. 1, sludge which possibly causes clogging of a filter is not generated and, therefore, a stable continuous processing can be performed over several months without any troubles.

The present invention will hereunder be described in more detail with reference to the following non-limitative working Examples. Moreover, the effects practically achieved will also be discussed in detail in comparison with Comparative Examples given below.

Example 1

A primer composition having the following composition was âpplied to the surface of a smooth aluminum plate which had been degreased in an ordinary manner so that the coated amount thereof was 8.0 g/m$^2$ (weighed after drying) and then heated at 120 °C for 3 minutes.

Primer Composition

| Component | Amount (P.B.W) |
| --- | --- |
| Gelatin #680 for photograph (available from NITTA | 100 |

GELATIN CO., LTD.)

TiO₂: 30wt%/gelatin #680 for photograph: 3wt%/pure water: 67 wt% dispersion — 20

Tertrazine (yellow dye) — 2

2

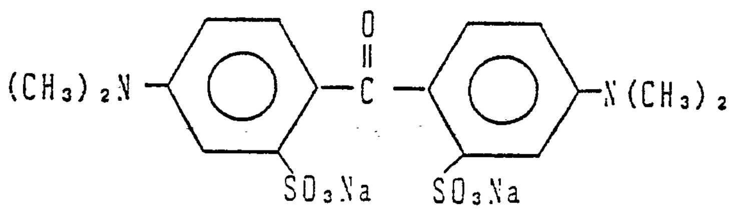

* P.B.W. means "parts by weight".

The following hardener solution was applied onto the resultant primer layer so that the coated amount thereof was 1.04 g/m² expressed in dry weight and was heated at 100°C for one minute to dry and harden the gelatin film.

| Component | Amount (P.B.W.) |
|---|---|
| $CH_2=CHSO_2CH_2CH(OH)CH_2SO_2CH=CH_2$ | 2 |
| Methyl alcohol | 70 |
| Pure water | 30 |

After drying and film hardening, the product was allowed to stand for one day at room temperature (about 20°C), the following light-sensitive composition was applied onto the primer layer so that the coated amount thereof was 1.0 g/m² expressed in dry weight and then was dried.

| Component | Amount (P.B.W.) |
|---|---|
| Copolymer of allyl methacrylate and sodium | 100 |

| | |
|---|---|
| methacrylate (content of sodium methacrylate = 15 mole%) | |
| Epoxy acrylate of the formula: $HOCH-(CH_2OCH_2CH(OH)CH_2OCOCH=CH_2)_2$ | 30 |
| 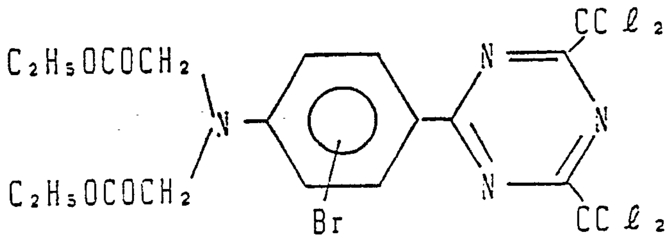 | 10 |
| Deifenser MCF323 (available from DAINIPPON INK & CHEMICALS, INC.) | 1 |
| Methyl ethyl ketone | 350 |
| Propylene glycol monomethyl ether | 330 |

Then the following silicone rubber composition was applied onto the light-sensitive layer so that the coated amount thereof was 1.7 g/m$^2$ expressed in dry weight and was dried to obtain a silicone rubber layer.

| Component | Amount (P.B.W.) |
|---|---|
| Dimethyl polysiloxane having vinyl groups at both terminals (molecular weight = about 35,000) | 100 |
| Methyl hydrogen polysiloxane having trimethylsilyl groups at both terminals (mlecular weight = about 2,500) | 3 |
| Olefin-chloroplatinic acid catalyst (10% toluene solution) | 2 |
| Isopar G (available from ESSO CHEMICALS, INC.) | 1800 |

A PET film whose one side had been matted and having a thickness of 6.5 µ was laminated with the silicone rubber layer thus obtained to form a dry PS plate.

A positive film was superposed on the resultant plate, closely came into contact therewith in vacuo and was imagewise exposed to light using a conventional exposure device and then the laminate film was removed.

On the other hand, the following aqueous developer (18ℓ ) was introduced into a tank of an automatic developing machine as shown in Fig. 1. The exposed dry PS plates were processed with this automatic developing machine.

Developer

| Component | Amount (P.B.W.) |
|---|---|
| Benzyl alcohol | 8 |
| New Cool B4SN (60 WT% aqueous solution; available from NIPPON EMULSIFYING AGENT MANUFACTURING CO. LTD.) | 9 |
| 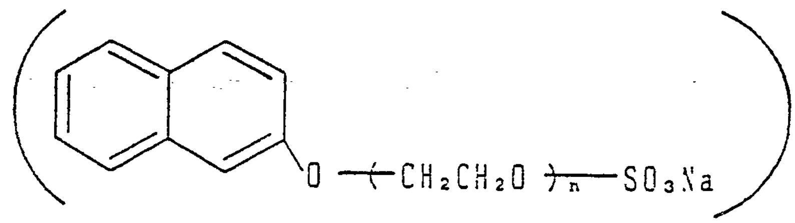 | |
| Triethanolamine | 1 |
| Pure water | 82 |

After 300 PS plates (1003 mm X 800 mm) were processed, the developer equivalent to the loss due to carrying over (1.3ℓ was supplemented. After additional 300 PS plates of the same size were further processed, 1.3 ℓ of the developer was again supplemented. Likewise, the developer (1.3ℓ each) was supplemented every time 300 PS plates were processed and thus 1350 PS plates in all were processed. Sludge was not formed during the processing and a filter did not cause clogging. Alternatively, for the purpose of examining the sensitivity, PS plates on which a step tablet (15 steps in all; difference in optical density between the neighbouring two steps being 0.15) had been printed were simultaneously processed. The difference in solid step numbers between the initial plate and the final plate was within one step. The pH value of the developer was slightly decreased during the processing, i.e., it was 9.80 after processing 38 plates and 9.18 after the completion of the processing. However, the developing properties thereof was not impaired at all.

Comparative Example 1

A dry PS plate obtained in the same manner as in Example 1 was exposed to light through a positive transparency superposed thereon as in Example 1 and then the laminate film was removed.

On the other hand, 18 ℓ of the following aqueous developer was charged into a tank of an automatic developing machine as shown in Fig. 1. The exposed dry PS plate was processed using the automatic developing machine.

| Developer | |
|---|---|
| Component | Amount (P.B.W.) |
| Benzyl alcohol | 8 |
| New Cool B4SN | 9 |
| Pure water | 83 |

After 300 Plates (1003 mm X 800 mm) were processed, the solid step number of the previously printed step tablet and the image reproducibility were compared with those observed on the plate which was processed at the beginning of the processing. However, there was observed no difference therebetween.

When 300 plates of the same PS plates were further processed, sludge was generated, there was observed a tendency of causing incomplete development and the solid step number was changed by about two steps. At this stage, 2.6ℓ of the foregoing developer was supplemented. The developing properties

thereof was slightly restored, but it was inferior to that at the beginning of the processing.

Moreover, triethanolamine was added to the foregoing developer whose developing properties had been lowered to adjust pH to 10.2, the sludge formed was completely dissolved and the developing properties thereof was restored.

Example 2

An exposed dry PS plate was prepared by superposing a positive transparency on a dry PS plate obtained in the same manner as in Example 1, exposing it to light and then immediately removing the laminated film.

Besides, 18 ℓ of the following aqueous developer was charged into a tank of an automatic developing machine as shown in Fig. 1. The foregoing exposed dry PS plate was processed using this automatic developing machine.

Developer

| Component | Amount (P.B.W.) |
|---|---|
| Benzyl alcohol | 8 |
| New Cool B4SN | 9 |
| Sodium carbonate ($Na_2CO_3$) | 1 |
| Dequest 2015DN (available from Mitsubishi Monsanto Chemical Company) | 0.025 |

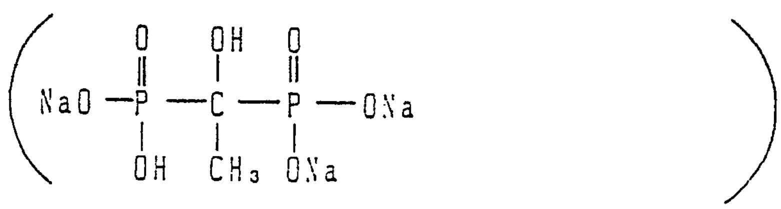

.

| | |
|---|---|
| Deionized water | 83 |

600 PS Plates (1003 mm X 800 mm) were processed. However, there was not observed the generation of sludge.

**Claims**

1. A developer for developing a dry presensitized plate for use in making lithographic printing plates requiring no dampening water during printing, comprising a substrate provided thereon with, in order, a primer layer, a light-sensitive layer and a silicone rubber layer; the developer comprising:

(i) at least one organic solvent capable of dissolving or swelling unexposed portions of the light-sensitive layer and whose solubility in water at ordinary temperature is not more than 20% by weight;

(ii) at least one basic compound;

(iii) at least one surfactant; and

(iv) water.

2. A developer of claim 1 wherein the organic solvent is at least one member selected from the group consisting of diisobutyl ketone, acetophenone, isophorone, diethyl succinate, methyl benzoate, diethyl oxalate, dimethyl phthalate, isobutyl acetate, benzyl benzoate, ethylene glycol monophenyl ether, ethylene glycol dibutyl ether, ethylene glycol benzyl ether, diethylene glycol di-n-butyl ether, ethylene glycol diacetate, n-amyl alcohol and benzyl alcohol.

3. A developer of claim 2 wherein the organic solvent is at least one member selected from the group consisting of diethyl succinate, dimethyl phthalate, benzyl benzoate, ethylene glycol monophenyl ether, diethylene glycol di-n-butyl ether, ethylene glycol diacetate and benzyl alcohol.

4. A developer of claim 1 wherein the amount of the organic solvent ranges from 1 to 30% by weight on the basis of the total weight of the developer.

5. A developer of claim 4 wherein the amount of the organic solvent ranges from 2 to 20% by weight on the basis of the total weight of the developer.

6. A develper of claim 1 wherein the basic compound is at least one member selected from the group consisting of ammonia, methylamine, ethylamine, dimethylamine, diethylamine, trimethylamine, triethylamine, propylamine, butylamine, amylamine, dipropylamine, dibutylamine, diamylamine, tripropylamine, tributylamine, methyldiethylamine, ethylenediamine, trimethylenediamine, tetramethylenediamine, polyethyleneimine, benzylamine, N,N-dimethylbenzylamine, N,N-diethylbenzylamine, N,N-dipropylbenzylamine, o-, m- or p-methoxy- or methyl-benzylamine, N,N-di(methoxybenzyl)-amine, $\beta$ -phenylethylamine, $\epsilon$ , $\delta$ -phenylamylamine, $\gamma$ -phenylpropylamine, cyclohexylamine, aniline, monomethylaniline, dimethylaniline, toluidine, benzidine, $\alpha$ - or $\beta$-naphthylamine, o-, m- or p-phenylenediamine, pyrrolidine, piperidine, piperazine, morpholine, urotropin, diazabicycloundecane, pyrrole, pyridine, quinoline, hydrazine, phenylhydrazine, N,N$'$-diphenylhydrazine, hydroxylamine, semicarbazide, tetraalkyl ammonium hydroxide, aminobenzoic acid, formamide, acetamide, N,N-dimethylformamide, N,N-dimethylacetamide, acetoanilide, monoethanolamine, triethanolamine, 2-(2-aminoethyl)-ethanol, 2-amino-2-methyl-1,3-propanediol, 2-amino-1,3-propanediol, 2-amino-2-hydroxymethyl-1,3-propanediol; salts of octanoic acid with monoethanolamine or diethanolamine, sodium methylate, sodium ethylate, sodium propylate, potassium methylate, potassium ethylate, potassium propylate, lithium methylate, lithium ethylate; amide, ethylamide and dipropylamide of sodium, potassium and lithium; sodium hydroxide, potassium hydroxide, lithium hydroxide, calcium hydroxide, barium hydroxide, sodium carbonate, potassium carbonate, lithium carbonate, calcium carbonate, barium carbonate, sodium bicarbonate, potassium bicarbonate, sodium phosphate, potassium phosphate, sodium silicate, potassium silicate and sodium metasilicate.

7. A developer of claim 1 wherein the basic compound is added to the developer in an amount required for adjusting pH of the developer to 8.5 to 11.5.

8. A developer of claim 7 wherein the basic compound is added to the developer in an amount required for adjusting pH of the developer to 9 to 10.5.

9. A developer of claim 1 wherein the surfactant is selected from anionic and non-ionic surfactants.

10. A developer of claim 9 wherein the surfactant is at least one member selected from the group consisting of alkylnaphthalene sulfonate salts, alkyl diphenyl ether sulfonate salts, linear alkylbenzene sulfonate salts, polyoxyethylene alkylphenyl ether sulfate ester salts, polyoxyethylene alkylphenyl ethers and polyoxyethylene-polyoxypropylene block copolymers.

11. A developer of claim 1 wherein the amount of the surfactant ranges from 0.01 to 30% by weight on the basis of the total weight of the developer.

12. A developer of claim 11 wherein the amount of the surfactant ranges from 0.1 to 20% by weight on the basis of the total weight of the developer.

13. A developer of claim 1 wherein the amount of the organic solvent ranges from 2 to 20% by weight on the basis of the total weight of the developer; the basic compound is added to the developer in an amount required for adjusting pH of the developer to 9 to 10.5; and the amount of the surfactant ranges from 0.1 to 20% by weight on the basis of the total weight of the developer.

14. A developer of claim 1 wherein it further comprises at least one dye to stain image areas simultaneously with the development.

15. A developer of claim 1 wherein the light-sensitive layer of the dry presensitized plate comprises i) 1.0 to 99.9 parts by weight of monomers which have a boiling point of not less than 100° C, which are non-volatile at room temperature and which have at least one photopolymerizable ethylenically unsaturated double bond; ii) 0.1 to 20.0 parts by weight of a photopolymerization initiator; optionally iii) 0.01 to 1.0 parts by weight of a heat polymerization inhibitor; and optionally iv) 0.01 to 95.0 parts by weight of polymers or inorganic powder.

16. A developer of claim 1 wherein the light-sensitive layer of the dry presensitized plate comprises a) copolymers which are soluble in water or get swallen with water at ordinary temperature and whose copolymerization components are at least a monomer represented by the following general formula (I):

$CH_2 = CR\text{-}CO\text{-}Z\text{-}C(R_4)(R_5)\text{-}C(R_3) = C(R_2)(R_1)$ (I)

(wherein R represents a hydrogen arom or a methyl group; $R_1$ to $R_5$ each represents a hydrogen or halogen atom, or a carboxyl, sulfo, nitro, cyano, amido, amino, alkyl, aryl, alkoxy, aryloxy, alkylamino, arylamino, alkylsulfonyl or arylsulfonyl group; Z represents an oxygen or sulfur atom or a group -NH- or $-NR'-$ (wherein $R'$ is an alkyl group)) and an ethylenically unsaturated monomer having hydrophilic group(s); b) a monomer or an oligomer having at least one photopolymerizable ethylenically unsaturated double bond; and c) a photopolymerization initiator.

17. A developer of claim 1 wherein the silicone rubber layer of the dry presensitized plate mainly comprises linear organic polysiloxane having the following repeating units and a molecular weight ranging from several thousands to several tens of thousands:

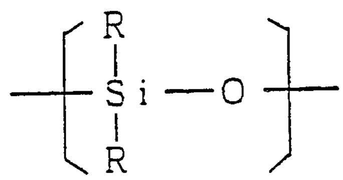

wherein R is an alkyl group having 1 to 10 carbon atoms, provided that not less than 60% of R is methyl group.

18. A developer of claim 1 wherein the primer layer of the dry presensitized plate is a layer of hardened gelatin, epoxy resin or polyurethane resin.

19. A developer of claim 1 wherein the substrate of the dry presensitized plate is an aluminum plate or a composite sheet composed of a polyethylene terephthalate film bonded to an aluminum plate.

20. A developer of claim 1 wherein the presensitized plate has a plastic protective layer.

FIG. 1